(19) Europäisches Patentamt

European Patent Office

Office européen des brevets

(11) **EP 2 610 935 A1**

(12) **EUROPEAN PATENT APPLICATION**

(43) Date of publication:
**03.07.2013 Bulletin 2013/27**

(51) Int Cl.:
*H01L 41/113* *(2006.01)*        *H02N 2/18* *(2006.01)*

(21) Application number: **12150003.7**

(22) Date of filing: **02.01.2012**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Stichting IMEC Nederland
5656 AE Eindhoven (NL)**

(72) Inventors:
• **Matova, Svetla
  5582 CE Waalre (NL)**

• **Brom Verheyden, Greja
  5551 AT Dommelen (NL)**
• **Van Schaijk, Rob
  5658 BH Eindhoven (NL)**

(74) Representative: **Krebs, Achim
  Haseltine Lake LLP
  Bezuidenhoutseweg 161
  2594 AG Den Haag (NL)**

(54)    **An energy harvesting device**

(57)    The present invention provides a piezoelectric energy harvesting device (100) comprising a cantilever arrangement having a first branch (120-1) arranged to be anchored at one end, a first piezoelectric energy generator provided on the first branch for generating a charge when the cantilever arrangement is caused to deform, a mass (130) coupled to the cantilever arrangement, and a counter-mass (160) adapted to cooperate with the mass for determining a mode of vibration of the cantilever arrangement. The present invention further provides a method and an apparatus.

Figure 1

**Description**

The invention relates to an energy harvesting device. In particular, the present invention relates to a piezoelectric energy harvesting device, a method for manufacturing the device, an apparatus for harvesting vibrational energy comprising the device, and a method for harvesting vibrational energy using the device.

Developments in electronic devices have seen continuous reduction in power consumption. Coupled with an increasing demand for system mobility and miniaturisation, much research effort has been put into the field of energy harvesting, in which ambient energy is converted into electrical energy, so as to eliminate the need for batteries. The energy thus harvested may be used for powering electronic circuits, for example, in personal electronic devices and various types of sensors, or stored for later use. A prominent application of energy harvesting is in wireless sensor nodes, where the difficulty and high cost associated with battery replacement for or providing wiring to the wireless sensor nodes makes the self-powering potential of energy harvesting particularly desirable.

Wireless sensor nodes (WSNs) are employed today to different extents in many areas, for example, wireless monitoring of heart rate and other bodily functions for biomedical applications, wireless monitoring of brain waves for brain-computer interfaces, tire pressure monitoring systems for improving the safety of automotive vehicle, detection of the presence of people for controlling energy consumption in buildings, continuous in-situ data detection and collection in infrastructure and machines for predictive maintenance, and active RFID tags, to name a few.

Currently, these devices rely mainly on battery power and therefore have limited lifetimes. Some devices require higher operating powers than others, but typically a small electronic product incorporating wireless sensor networks has a power requirement ranging from 1 μW to 1 W, giving a lifespan ranging from a few hours to a few years using commercially available batteries. Thus, the common need of WSNs for a long lifespan and miniaturisation cannot be satisfied by the power density of currently available battery technology.

Therefore, energy harvesting is a promising solution for allowing WSNs to perform their sensing functions and wireless communications without supervision, configuration, or maintenance, making WSNs truly autonomous.

Energy harvesting provides an essentially limitless energy source capable of powering wireless sensor nodes. Numerous ambient energy sources for energy harvesting have been considered, including solar, thermal gradients, acoustic waves and mechanical vibrations. The choice of energy source is heavily dependent on environmental conditions and is thus application dependent.

For converting motion or vibration, the three main transduction mechanisms are electrostatic, electromagnetic, and piezoelectric. In electrostatic transducers, motions or vibrations cause the distance between the two electrodes of a polarized capacitor to vary. This change in distance causes a change in the voltage across the capacitor and results in a current flow in an external circuit. In electromagnetic transducers, the relative motion of a magnetic mass with respect to a coil causes a change in magnetic flux, generating an AC current in the coil. In piezoelectric transducers, motions or vibrations cause the deformation of a piezoelectric capacitor, thereby generating a charge.

Amongst the vibration energy harvesters, electromagnetic harvesters are generally bulky, while electrostatic harvesters require a separate voltage source. On the other hand, piezoelectric generators can be made smaller due to their higher energy density (35.4 mJcm$^{-3}$) compared to electromagnetic (24.8 mJcm$^{-3}$) and electrostatic (4 mJcm$^{-3}$) generators.

When mechanically strained, piezoelectric materials generate charges which can be harvested, either to be stored or immediately used, to power electronic circuits. Typical piezoelectric energy harvesters consist of a cantilevere bimorph or unimorph structure mechanically connected to a vibrating host structure. The strained piezoelectric element produces an electric potential between a pair of electrodes. The maximum power $P_{max}$ that can be output by a given piezoelectric energy harvesting beam generally follows Eq. (1),

$$P_{max} = \frac{1}{4}\frac{m}{\omega}Q^2 A^2 k_{31}^2 \qquad\qquad (1)$$

where m is the mass of the beam, A is the vibration amplitude, w is the resonant frequency of the beam, $k_{31}$ is the transverse electromechanical coupling factor and Q is the quality factor. The quality factor Q quantifies the mechanical and electrical damping of the system. As seen in Eq. (1), it is desirable to operate the harvester at a low vibration mode with a high amplitude of vibration to achieve a higher power.

In a cantilever arrangement comprising a single cantilever beam of length $l_b$ and a tip-mass of mass M and length $l_M$ provided at the free end of the cantilever beam, the resonant frequency of the cantilever arrangement is given by Eq. (2),

$$\omega^2 = \frac{3EI}{Ml_b^3} \cdot \frac{1}{1 + \frac{l_M}{2l_b} + \frac{3l_M^2}{4l_b^2}} \,, \qquad\qquad (2)$$

where E is the Young's modulus and I is the cross-sectional area moment of inertia of the cantilever beam.

It can be seen that the resonant frequency of the cantilever arrangement is approximately inversely proportional to $\sqrt{Ml_b^3}$. In other words, increasing the weight of the tip-mass and the length of the cantilever beam lowers the resonant frequency of the cantilever arrangement. Therefore, in order to achieve a low resonant frequency to improve power output, the mass and/or the length of the cantilever must be increased. However, in many sensor node applications, such as structural health monitoring and biomedical applications, it is desirable or even necessary to minimize sensor node size. The mass and length of such systems are therefore restricted, and the power output limited.

It is therefore desirable to provide an energy harvester that is compact and yet capable of high power output.

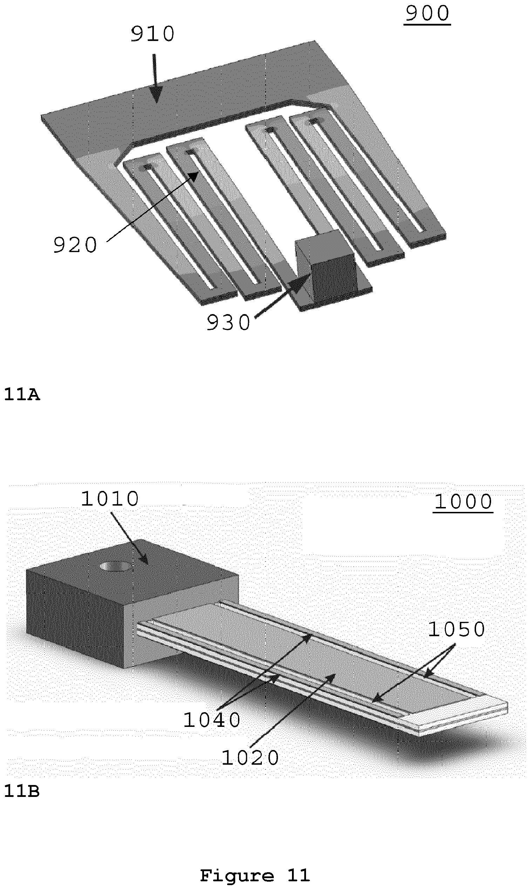

"Compact low frequency meandered piezoelectric energy harvester", by Berdy et al (PowerMEMS, December 2009) discloses a piezoelectric energy harvester 900, shown in **Figure 11A**, in which a cantilever beam is arranged in a folded configuration with multiple parallel branches 920 coupled to the adjacent one at alternate ends, one end 910 of the two outermost branches are anchored to a vibrating host structure, while a tip mass 930 is disposed at the unanchored free end of the cantilever to increase the vibration amplitude and reduce the resonant frequency of the cantilever. The folded-beam configuration decreases the spring constant of the energy harvester compared to a straight-beam cantilever of the same overall length, thus achieving a lower resonant frequency while being more compact.

However, even a small difference between the excitation frequency of the vibration source and the resonant frequency of the energy harvester leads to a poor power output due to an increase in mechanical damping. Moreover, even when the resonant frequency of the cantilever was tuned to match the excitation frequency of the vibration source at installation, the resonant frequency may deviate from the tuned frequency during operation due to wear and tear and/or the excitation frequency received at the energy harvester may change due to changes to the environment.

It is therefore further desirable to provide an energy harvester, the mechanical characteristics of which may be adjusted in situ, thereby optimising the efficiency of the energy harvester.

"A piezoelectric harvester with an integrated frequency-tuning mechanism", by Eichhorn et al (Power MEMS, December 2009) discloses a piezoelectric energy harvester 1000, shown in **Figure 11B**, with a straight-beam cantilever, in which two lateral arms 1040 in the form of two strips of piezoelectric material are provided alongside a central main beam 1020 of piezoelectric material of the same type, separated by gaps 1050. The two arms 1040 are arranged in parallel with the main beam 1020 and function as actuators for controlling the resonant frequency of the cantilever upon application of a voltage.

However, the lateral actuator arms disclosed in the latter document cannot be easily adapted to the folded-beam cantilever configuration disclosed in the former document due to the resulting complexity in determining the relationship between the voltage applied to the actuator arms and the resonant frequency of the cantilever.

Moreover, when the folded-beam cantilever is deformed, the strain induced in the piezoelectric material on different branches may have different signs as some branches experience compressive stress while others experience tensile stress. The negative and positive strains respectively produce positive and negative charges. If a single set of electrodes is provided to the piezoelectric element of each branch to collect the charges produced at that branch, the positive and negative charges cancel out and the power output is significantly reduced. Consequently, a folded-beam cantilever configuration requires a more complicated arrangement of electrodes, and if further electrodes must be provided in order to incorporate actuator arms for each branch, the resulting device then becomes even more complicated.

In view of the foregoing, an embodiment of an aspect of the present invention provides a piezoelectric energy harvesting device, which comprises a cantilever arrangement having a first branch arranged to be anchored at one end, a first piezoelectric energy generator provided on the first branch for generating a charge when the cantilever arrangement is caused to deform, a mass coupled to the cantilever arrangement, and a counter-mass adapted to cooperate with the mass for determining a mode of vibration of the cantilever arrangement. As a result of the cooperation between the mass and the counter-mass, the mode of vibration can be fixed to a desired shape and frequency.

The counter-mass of the piezoelectric energy harvesting device may be further adapted to co-operate with the mass to determine the stress distribution of the cantilever arrangement, such that only tensile stress or only compressive stress is induced in the cantilever arrangement when the cantilever arrangement is caused to deform. The mass and the counter-mass are arranged in such a way that one of the two types of stress induced in the cantilever arrangement by the mass is cancelled by the contribution from the counter-mass, thus the arrangement of the electrodes can be hugely simplified.

The piezoelectric energy harvesting device may further comprise a second piezoelectric energy generator. In this case, the cantilever arrangement would further comprise a second branch arranged to be anchored at one end, on which the second piezoelectric energy generator is provided for generating a charge when the cantilever arrangement is caused to deform, and the first and second branches would be coupled by the counter-mass at or towards the free end of the first and second branches. The second piezoelectric energy generator may or may not be made of the same piezoelectric material. Together, the first and second piezoelectric energy generators generate a higher power output.

Preferably, the piezoelectric energy harvesting device further comprises a tuning means configured to adjust the resonant frequency of the cantilever arrangement, wherein the cantilever arrangement further comprises a third branch coupled to the first and second branches, the tuning means being provided on the third branch. Through the use of the tuning means, it is possible to adjust the resonant frequency of the cantilever arrangement in situ, so that the resonant frequency is tuned to the excitation frequency of the vibration source, thereby optimising the power output efficiency of the piezoelectric energy harvesting device. Furthermore, since the tuning means is provided on a different branch of the cantilever arrangement separated from the first and second piezoelectric energy generators, it is possible to position the tuning means based on specific needs. Incidentally, the counter-mass may be omitted in this embodiment provided that the electrodes provided to the first and second piezoelectric energy generators are suitably adapted for collecting charges of both positive and negative signs.

The tuning means of the piezoelectric energy harvesting device may be a piezoelectric actuator arranged to vary the resonant frequency of the cantilever arrangement in accordance with a DC voltage applied thereto. Since the applied DC voltage can be controlled to vary, it is possible to determine the changes in the resonant frequency as a function of the applied voltage, and thus the resonant frequency can be accurately tuned.

The third branch having the tuning means provided thereon may be positioned at any point along the length of the first and second branches. However, to maximise the total power output that can be harvested by the device, it is preferable to position the third branch towards the free end of the first and second branches. In an embodiment of the piezoelectric energy harvesting device, the third branch may be coupled to the first and second branches by the counter-mass and positioned at or towards the free end of the first and second branches. The stress/strain induced in the first and second branches is highest towards the anchored end, and so the charges generated by the first and second piezoelectric generators have the highest density in that region. On the other hand, the stress/strain reduces significantly towards the free end of the first and second branches and that region of the first and second piezoelectric generators does not contribute much to the total power output. In this embodiment, the region that generates the highest charge density is exclusively used for energy harvesting, whereas the stiffness of the region that generates the lowest charge density is adjusted by the tuning means for tuning the resonant frequency. Thus, both the power output of the piezoelectric generators and the tuning range achievable by the tuning means are optimised.

The mass of the piezoelectric energy harvesting device may be coupled to the counter-mass by the third branch, the counter-mass being disposed at or towards the free end of the first and second branches, such that the mass is disposed in a region defined by the first, second and third branches. This arrangement of the mass and the counter-mass optimises space efficiency and allows the device to be more compact.

Preferably, the piezoelectric material of the piezoelectric actuator has a high piezoelectric strain constant $d_{31}$, preferably at least 23pm/V. Such a material includes PZT. When a given voltage is applied to a piece of piezoelectric material, it results in larger mechanical deformation in material with a higher strain constant. Therefore, a piezoelectric material with a high strain constant is capable of producing more torque for a given voltage, and is therefore better suited as an actuator.

Preferably, either one or both of the first and second piezoelectric energy generators comprises piezoelectric material having a low dielectric constant $\varepsilon_r$, preferably no greater than 6.2, and a high piezoelectric stress constant $e_{31}$, preferably at least =0.06C/m$^2$. Such a material includes AlN. The dielectric constant of a piezoelectric material characterises its capacitance. A piezoelectric material with a lower capacitance has the advantage of achieving a higher power output compared to material with a higher capacitance for the same dimensions and under the same excitation conditions.

A piezoelectric energy harvesting device according to the present invention may be implemented in a micro-electro-mechanical system (MEMS) or a nano-electro-mechanical system (NEMS) for powering the system.

An embodiment of another aspect of the present invention provides a method for manufacturing a piezoelectric energy harvesting device. The method comprises the steps of providing on a first branch of a cantilever arrangement that is anchored at one end with a first piezoelectric energy generator for generating a charge when the cantilever arrangement is caused to deform, setting a target resonant frequency and determining the weight of a mass and the weight of a counter-mass based on the target resonant frequency, such that the mass and the counter-mass cooperate to determine a mode of vibration of the cantilever arrangement, and coupling the mass and the counter-mass having the determined weights to the cantilever arrangement.

The method may further comprise the step of providing a tuning means to a third branch of the cantilever arrangement, the third branch being coupled to the first and second branches, for adjusting the resonant frequency of the cantilever arrangement.

An embodiment of a further aspect of the present invention provides an apparatus for harvesting vibrational energy as electrical energy. The apparatus comprising a circuit, one or more of the piezoelectric energy harvesting devices as summarised above, and distribution means for distributing the charges generated by the one or more devices as electrical energy to the circuit for powering the circuit.

The distribution means may comprise storage means for storing the charges generated by the one or more piezoelectric energy harvesting devices when the circuit has no immediate need for power.

The apparatus may be provided with a plurality of the piezoelectric energy harvesting devices where one or more of the plurality of devices are configured to operate at different resonant frequencies, such that vibration energy at a wide range of frequencies may be captured.

An embodiment of another further aspect of the present invention provides a method for harvesting energy from a source of vibration as electric energy using the piezoelectric energy harvesting device. The method comprises the steps of disposing the device in the proximity of the source such that the vibration causes the cantilever arrangement to deform, collecting the charges produced, when the cantilever arrangement is deformed, by one or both of the first piezoelectric energy generator and the second piezoelectric energy generator, and adjusting the resonant frequency of the cantilever arrangement according to the vibration frequency of the source by varying the DC voltage applied to the piezoelectric actuator.

The present invention will now be described, by way of examples only, with reference to the attached drawings, in which:

Figures 1A to 1D are schematic views of an embodiment of a piezoelectric energy harvesting device according to the present invention;

Figure 2 is a schematic view of a comparison example of a piezoelectric energy harvesting device;

Figures 3A and 3B are graphs showing the effect of varying the dimension of the counter-mass on the resonant frequency and the stress distribution along a harvester beam of the piezoelectric energy harvesting device of Figure 1D;

Figures 4A and 4B are graphs showing the effect of applying different DC voltages to the actuator beam on the resonant frequency and maximum power output of the piezoelectric energy harvesting device of Figure 1D at a constant acceleration of 1g;

Figure 5 is a graph showing the effect of applying different DC voltages to the actuator beam on the resonant frequency and maximum power output of the piezoelectric energy harvesting device of Figure 1D at a constant maximum displacement of 600$\mu$m;

Figure 6 is a table showing the piezoelectric and dielectric properties of various materials;

Figure 7 is a graph showing a comparison of the stress distribution along a harvester beam and along the actuator beam of the piezoelectric energy harvesting device of Figure 1D;

Figures 8A and 8B are schematic views of two alternative embodiments of a piezoelectric energy harvesting device according to the present invention;

Figures 9A and 9B are flow charts depicting a method of fabricating an embodiment of a piezoelectric energy harvesting device according to the present invention and harvesting energy from a vibration source using the device;

Figure 10A and 10B are schematic views of an electromechanical model and an electrical macro model of the piezoelectric energy harvesting device of Figure 1D; and

Figures 11A and 11B are schematic views of respective prior art examples of a piezoelectric energy harvesting device.

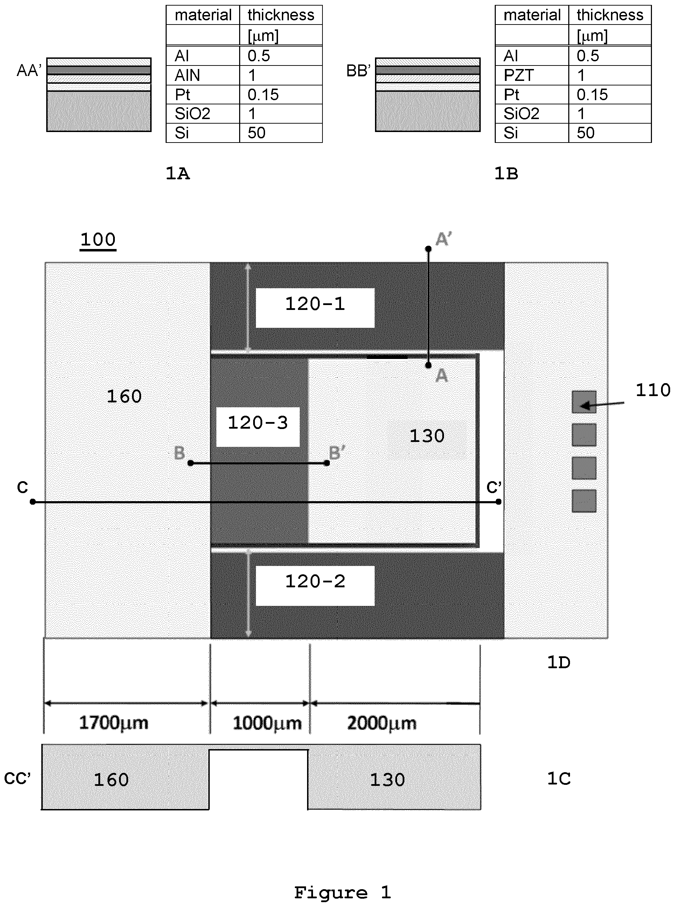

An embodiment of a piezoelectric energy harvesting device according to the present invention is shown in **Figure 1D.**

The device 100 comprises a cantilever arrangement provided on the top side of a substrate, for example a silicon oxide substrate. The cantilever arrangement includes three branches 120-1, 120-2 and 120-3, where the first branch 120-1 and the second branch 120-2 are each anchored at one end by anchoring means 110 to a vibrating source (not shown). The silicon oxide substrate extends across the free end of the first branch 120-1 and the second branch 120-2, forming an intersection portion, where a counter-mass 160 is attached to the underside of the intersection portion, such that the counter-mass 160 is coupled to each of the first branch 120-1 and the second branch 120-2 via the silicon oxide substrate. Each of the first branch 120-1 and the second branch 120-2 is separated from a centre portion of the silicon oxide substrate, which extends from the intersection portion towards the anchoring means 110, by a narrow gap. The third branch 120-3 is provided on the top side of the centre portion adjacent to the counter-mass 160, between the counter-mass 160 and a mass 130 that is attached to the underside of the centre portion. The third branch 120-3 and the mass 130 are therefore coupled to the first and second branches 120-1, 120-2 via the counter-mass 160.

For simplicity, in this embodiment, both the mass 130 and the counter-mass 160 are made of the same material, in this case silicon, so that the weight of the mass 130 and the weight of the counter-mass 160 are proportional to their dimensions. However, different material may be used for each or both of the mass 130 and the counter-mass 160, if desired.

The counter-mass 160 is provided towards the free end of the device in this embodiment so as to achieve the desired vibration mode when the first and second branches 120-1, 120-2 vibrate. In particular, the counter-mass 160 acts on the first and second branches 120-1, 120-2 such that they vibrate in a vibration mode with a single peak (or valley) involving only one-dimensional motions in the plane perpendicular to the plane of the cantilever arrangement, whereas without the counter-mass 160, the first and second branches 120-1, 120-2 vibrate with more complex mode shapes with both peaks and valleys involving two-dimensional twisting motions. By virtue of the one-dimensional vibration motions and single peak (valley) mode shape, the first and second branches 120-1, 120-2 only experience a purely compressive or purely tensile stress distribution along their length when deformed by the vibrations from the vibration source.

The dimensions, and therefore weight, of the mass 130 and the counter-mass 160 are determined by the target resonant frequency, and constrained by the overall size of the device based on its application. For example, when the device is implemented in a vibration health monitoring system for a piece of machinery that vibrates at a frequency of about 650 Hz, the target resonance frequency would then be about 650Hz, and the size of the device is determined by the available space at the position on the piece of machinery where the device is disposed, for example, the device may have dimensions of $5000{\times}5000{\times}675\mu m$ (lengthxwidthxthickness, respectively). The dimensions of the mass, being provided in the centre portion, are restricted by the size of the first, second and third branches, and in the present embodiment are chosen to be $2000{\times}200{\times}675\mu m$. To further simplify the design of the device, the weight of the counter-mass is varied by varying only its length in the longitudinal direction of the first and second branches in the present embodiment; the width and the thickness of the counter-mass are kept constant. In this way, the resonance frequency of the device may be fixed by design in accordance with the length of the counter-mass 160, which can be determined by any suitable method such as finite element modelling (FEM).

The dimensions and materials of the various portions of the device 100 shown in Figure 1 are examples only. In order to illustrate the various aspects of the embodiment, these examples are used in various simulations of the properties of the device, the results of which will be discussed at a later point.

Three cross-sections, AA', BB' and CC', are shown in **Figures 1A, 1B** and **1C**, respectively, in order to illustrate the embodiment more clearly. Cross-section AA' shows the different layers of material used in this embodiment to form the first branch 120-1, which includes an AlN piezoelectric layer disposed between a Pt electrode layer and an Al electrode layer, forming a first piezoelectric energy generator. In this embodiment, the second branch 120-2 has the same composition as the first branch 120-1, and so a cross-section of the second branch 120-2 is not shown. Cross-section BB' shows the different layers of material used in this embodiment to form the third branch 120-3, which includes a PZT piezoelectric layer disposed between a Pt electrode layer and an Al electrode layer, forming a piezoelectric actuator that functions as a tuning means. Cross-section CC' shows a side view across the counter-mass 160, the third branch 120-3 and the mass 130.

In use, vibrations from the vibration source (not shown) are transferred to the first branch 120-1 and the second branch 120-2 by the anchoring means 110, causing the first branch 120-1 and the second branch 120-2 to deform. The deformation of the first branch 120-1 and the second branch 120-2 is enhanced by the mass 130 and the counter-mass 160. The deformation causes a built-up of charges across the respective AlN piezoelectric layers of the first and second branches 120-1, 120-2, which are collected by means of the respective Pt and Al electrode layers. Since the counter-mass 160 cooperates with the mass 130 to cancel out one of the two types of stress (compressive or tensile) in the first and second branches 120-1, 120-2, it is possible for the electrode layers to straightforwardly collect all the charges produced by the AlN piezoelectric layers. In a case where the resonant frequency of the first and second branches 120-1, 120-2 does not match the frequency of vibration of the vibration source, a DC voltage is applied to the Pt electrode layer and Al electrode layer across the PZT piezoelectric layer of the third branch 120-3. When a DC voltage is applied to the electrode layers, a potential difference is built up across the PZT piezoelectric layer, causing it to deform. The torque resulting from the deformation of the PZT piezoelectric layer alters the position of the neutral axis of vibration of the cantilever arrangement. In other words, the stiffness, or spring constant, of the cantilever arrangement may be adjusted in accordance with the sign and magnitude of the applied DC voltage. As the resonant frequency of a cantilever decreases with a decreasing spring constant, the resonant frequency of the cantilever arrangement can be adjusted simply by varying the DC voltage applied to the third branch 120-3.

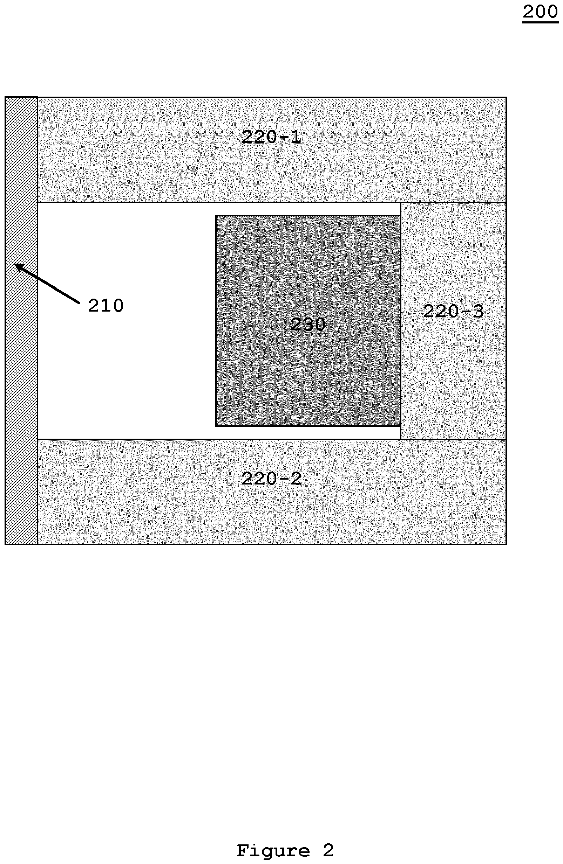

The electrodes above and below the energy harvesting piezoelectric layer may be suitably adapted, for example by means of diodes, to collect only charges of positive or negative sign. In this case, the counter-mass may be omitted and the first vibration mode may be determined by the dimensions of the mass only. Such a configuration is shown in **Figure 2** as a comparison example to the embodiment of Figure 1. In this example, the piezoelectric energy harvesting device 200 again comprises a first branch 220-1 and a second branch 220-2 anchored at one end by anchoring means 210. A third branch 220-3 is coupled to the first and second branch 220-1, 220-2, and a mass 230 is coupled to the third branch 220-3, by means of a silicon oxide substrate as in the embodiment of Figure 1. The composition of each of the first, second and third branches 220-1, 220-2, 220-3 is the same as in the embodiment of Figure 1 and so a detailed description is omitted.

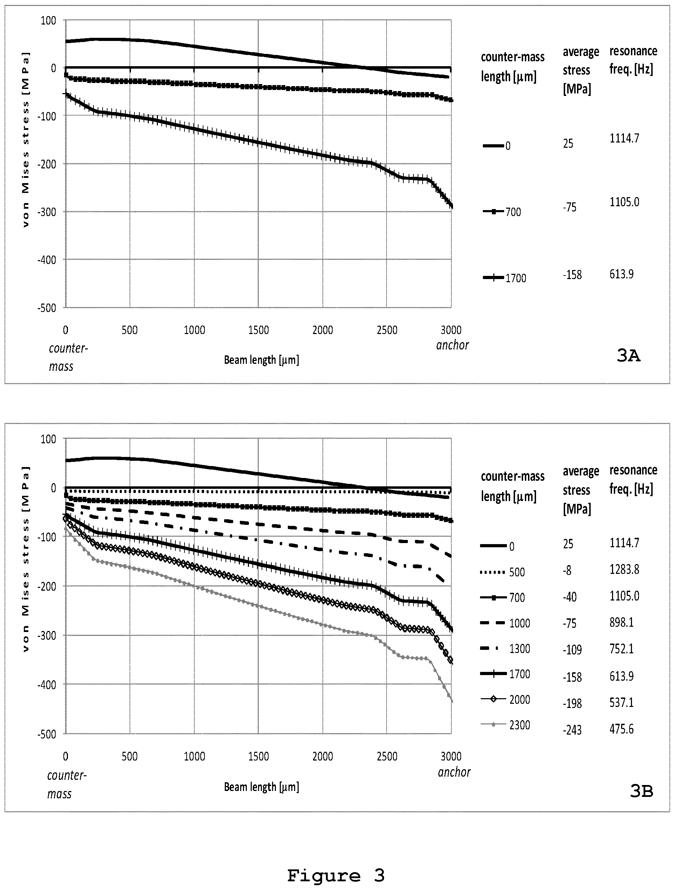

The stress distributions along one of the two energy harvesting branches (first branch or second branch) for piezoelectric energy harvesting devices with counter-masses of different dimensions are shown in **Figures 3A** and **3B**. The solid line with vertical hashes in Figure 3A shows the stress along the length of the first branch 120-1 (or the second branch 120-2) of the device 100 in Figure 1, whereas the plain solid line shows the stress along length of the first branch 220-1 (or the second branch 220-2) of the device 200 in Figure 2. Figure 3B shows the stress distributions of further examples with different dimension of counter-mass.

It can be seen that, when there is no counter-mass, as in the case of the device 200, the stress distribution along the first and second branches has two components - tensile and compressive (above and below the zero line). On the other hand, the presence of the counter-mass 160 cooperates with the mass 130 to cancel out one of the two components, and the stress experienced by the first and second branches remains purely compressive along the entire length of the harvesting beam. In practice, this means that the device 200 with no counter-mass requires split harvesting electrodes to be provided to the energy harvesting first and second branches to avoid charge cancelation, such that one set of electrodes of each branch is configured to harvest tensile-stress induced charges, and another is configured to harvest compressive-stress induced charges. On the contrary, the device 100 with the counter-mass 160 requires only a single set of electrodes for each of the energy harvesting first and second branches.

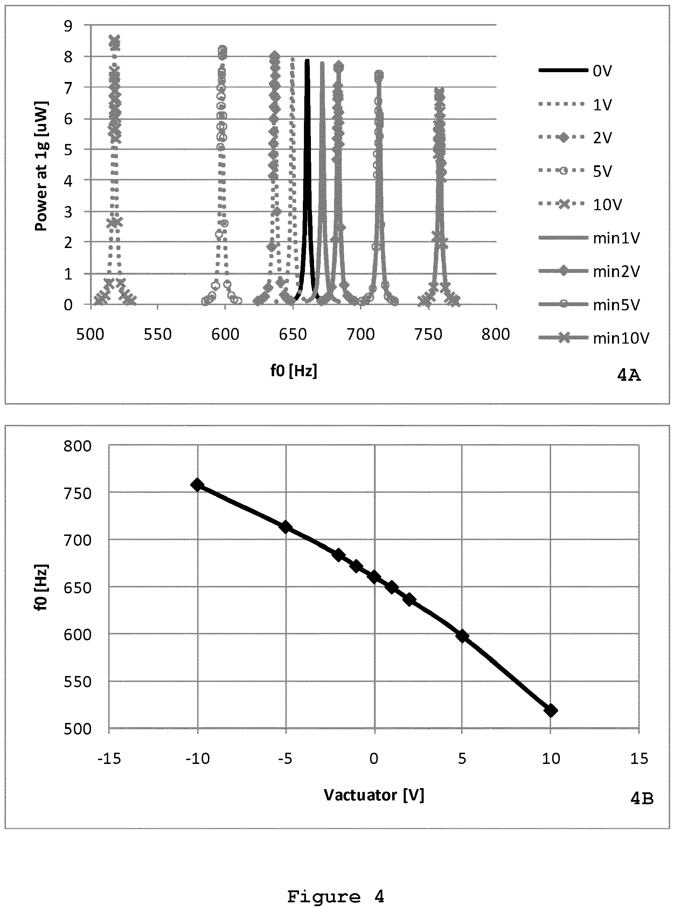

The effect of applying different DC voltages to the piezoelectric actuator on the third branch 120-3 of the device 100 on the maximum power output and on the resonant frequency of the device 100 at a constant acceleration force of 1g is shown in **Figures 4A** and **4B**. The polarity of the applied DC voltages has a softening or stiffening effect on the first and second branches, and respectively causes a decrease or an increase in the output power. For the device 100, a change of 1 10V in the voltage applied to the piezoelectric actuator on the third branch 120-3 causes the resonant frequency to shift about 1 100 Hz (15%). The shift in resonant frequency translates to a shift in the maximum power output by the device 100 at resonance of up to 12.5%.

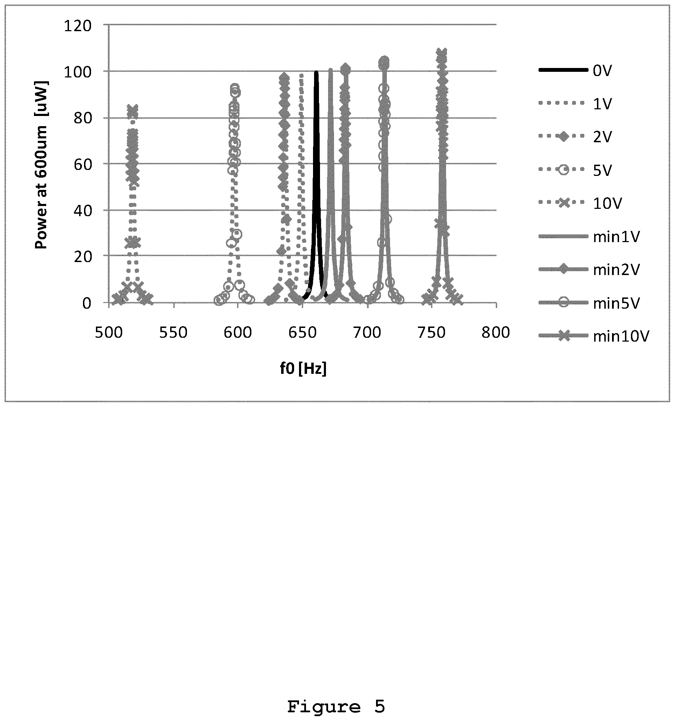

**Figure 5** shows the effect of applying different DC voltages to the piezoelectric actuator, provided on the third branch 120-3 of the device 100, on the maximum power output and on the resonant frequency of the device 100 at a constant maximum displacement of $600 \mu m$. At different applied voltages, the stiffness of the first and second branches 120-1, 120-2 accordingly changes, therefore, in order to maintain a constant maximum displacement (measured in respect of the tip of the mass 130) at different voltages, the magnitudes of the acceleration force induced on the device 100 must be accordingly adjusted. Consequently, the maximum power of the device 100 is influenced by the changes in the amount of stress/strain induced in the energy harvesting first and second branches 120-1, 120-2 and now increases towards the negative end of the applied voltage. Here, the shift in the maximum power at resonance may be up to 16.3%.

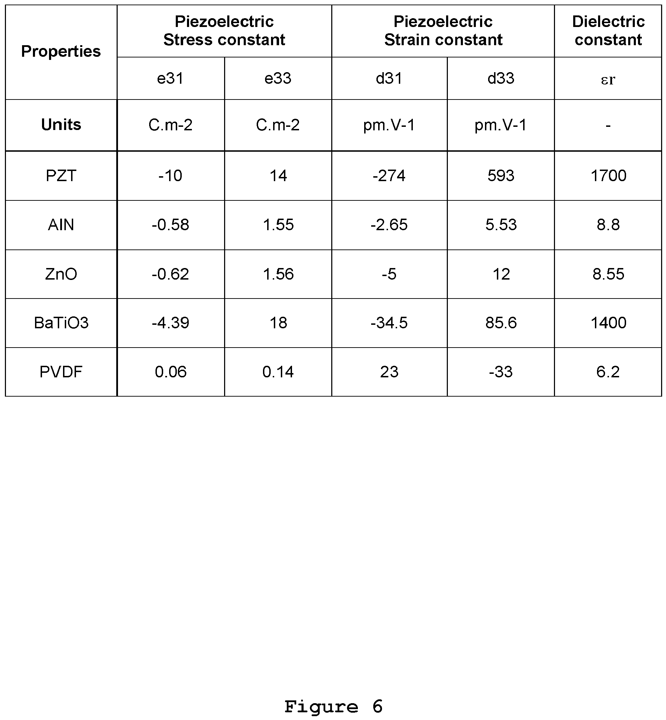

In the embodiment of Figure 1, the piezoelectric material used for the energy harvesting first and second branches 120-1, 120-2 is AlN (aluminum nitride), while for the tuning actuator third branch 120-3, it is PZT (lead zirconate titanate). The material properties of the two materials differ significantly. The piezoelectric stress and strain constants and dielectric constants of PZT and AlN are shown in the table of **Figure 6**, in which other examples of piezoelectric material are also included for comparison.

As can be seen from the table, PZT and $BaTiO_3$ have the highest stress and strain constants, meaning that these materials generate a high charge density when under stress, and are capable of large mechanical displacements when a voltage is applied across the materials. Therefore, PZT and $BaTiO_3$ are particularly suited for use as actuators. However, these materials also have very high dielectric constants, meaning that they both have a high capacitance. Although PZT and $BaTiO_3$ are capable of generating a higher charge density, their high capacitance means that only a small portion of the generated charge can be harvested and output.

On the other hand, AlN and ZnO have lower piezoelectric strain constants compared to PZT and $BaTiO_3$, and therefore do not perform as well as actuators compared to PZT and BaTiO3. AlN and ZnO also have lower values of piezoelectric stress constant, but the lower piezoelectric stress constants of these materials are compensated by their much lower dielectric constants. In other words, AlN and ZnO are more efficient as energy generators and are capable of higher power output compared to PZT and $BaTiO_3$.

It should be apparent that, in the embodiment of Figure 1, PZT is chosen to perform the function of a tuning means while AIN is chosen to perform the function of an energy generator as their material properties are more suited to the respective functions. However, as shown in the table of Figure 6, other materials may be equally suitable, and materials that are not listed in the table may be better suited for various reasons. It should therefore be noted that other materials may replace PZT and AIN in a device in accordance with the present invention, and it is not essential to use different materials for performing the functions of an actuator and an energy generator.

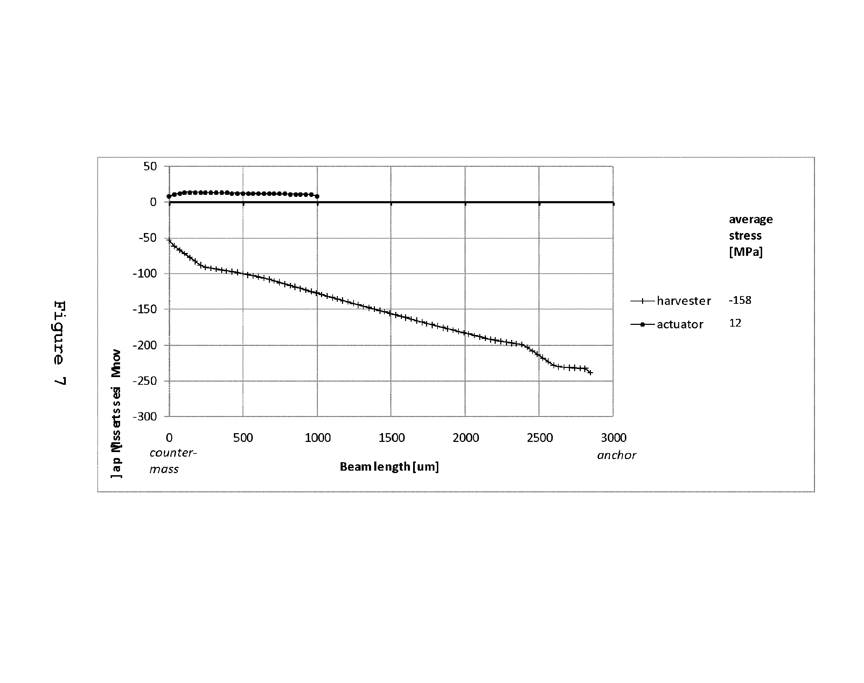

In the device 100, the third branch 120-3, on which a tuning means is provided, is disposed towards the free end of the first and second branches 120-1, 120-2. As shown in **Figure 7**, the energy harvesting first and second branches experience the highest stress/strain towards the anchored end, and so the highest charge density is generated in the piezoelectric material on the first and second branches in the region near the anchored end. Therefore, positioning the tuning means towards the free end is more preferable as the influence of the tuning mechanism on the energy-generating region is minimized. It should be noted that the third branch having the tuning means may be disposed at any position along the length of the first and second branches, despite its effect on energy generation, if such positioning is desired.

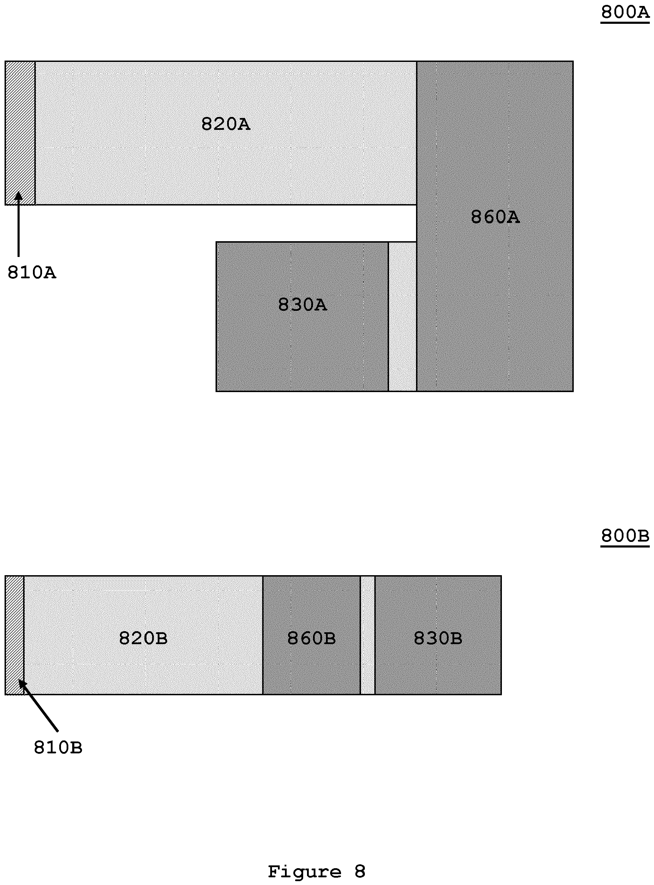

**Figures 8A** and **8B** show further embodiments of a piezoelectric energy generating device according to the present invention. Both device 800A, shown in Figure 8A, and device 800B, shown in Figure 8B, comprise only a single energy harvesting branch, 820A and 820B, respectively, which are anchored at one end by anchoring means 810A and 810B, respectively. Each of device 800A and device 800B comprises a mass, respectively 830A and 830B, and a counter-mass, respectively 860A and 860B. The respective energy generating branch 820A, 820B, mass 830A, 830B, and counter-mass 860A, 860B are coupled via a silicon oxide substrate as in the device 100. In the present embodiments, neither device 800A nor device 800B comprises a tuning branch. In this case, the resonant frequency and the first vibration mode of the devices 800A and 800B are determined by the dimensions (weights) and position of the mass 830A, 830B and the counter-mass 860A, 860B. Without a tuning branch, the resonant frequency of each of the devices 800A and 800B is fixed by design. However, it should be apparent to a person skilled in the art that an additional branch may be provided to the device 800A and/or the device 800B, for example, at a position between the mass 830A, 830B and the counter-mass 860A, 860B, on which a tuning means may be provided.

Compared to the device 800A, the device 100 is physically more convenient for the purpose of energy harvesting, since the first vibration mode involves simple displacement in the vertical direction with respect to the plane of the device without any twisting motion. On the other hand, compared to the device 800B, the device 100 has the advantage of having a more compact configuration, making it more suitable for a miniature system which imposes strict length requirement on the device.

It should be apparent to a person skilled in the art that other configurations of a piezoelectric energy harvesting device comprising one or more energy generating branches, a mass and a counter-mass, with or without a tuning branch are also possible without departing from the scope of the present invention.

On or more of the devices 100, 200, 800A and 800B may be implemented as a micro-electro-mechanical system or a nano-electro-mechanical system by any of the known fabrication processes such systems.

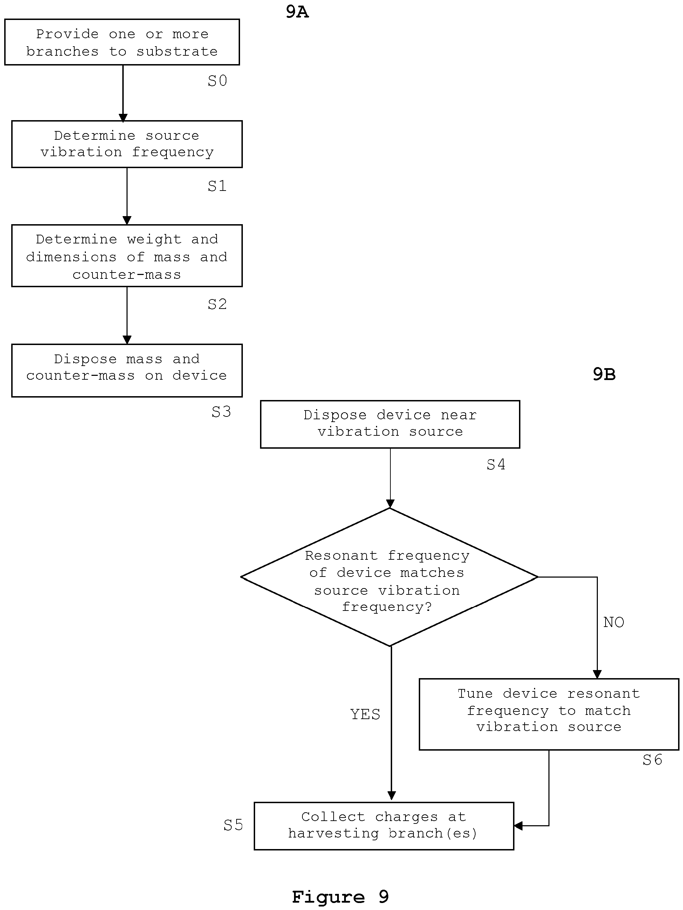

A flow chart depicting a method for fabricating and using a piezoelectric energy harvesting device such as the devices 100, 200, 800A and 800B for harvesting energy from a vibration source as electric energy is shown in **Figure 9A** and 9B, respectively.

For a chosen configuration of a piezoelectric energy harvesting device, for example, a configuration according to any of the devices 100, 200, 800A, 800B or other variants, one or more energy generating branches and/or a tuning branch are provided on a silicon oxide substrate at step S0, each branch being provided with a piezoelectric material disposed between a top electrode and a bottom electrode. Then, at step S1, the vibration frequency of the source is determined, which is to be treated as the target resonant frequency of the device. Next, the dimensions (weights) of the mass and the counter-mass are determined at step S2 by FEM simulations, according to the size constraint of the device, such that the resonant frequency of the device coincides with the target resonant frequency. A mass and a counter-mass having the determined dimensions (weights) are then disposed on the substrate of the piezoelectric energy harvesting device at step S3.

The resulting device is disposed, at step S4, in the proximity of the source of vibration and attached to the vibration source by suitable means, such that the vibration causes the cantilever arrangement of the device to deform, thereby charges are generated by one or more energy harvesting branches of the cantilever arrangement. The charges produced by the piezoelectric material on the one or more energy harvesting branches are collected, at step S5, by their respective electrodes, when the cantilever arrangement is deformed. If it is determined during operation that the resonant frequency of the cantilever arrangement does not match the vibration frequency of the vibration source, the resonant frequency of the cantilever arrangement is adjusted according to the vibration frequency of the source, at step S6, using the tuning means by applying a DC voltage to the tuning branch.

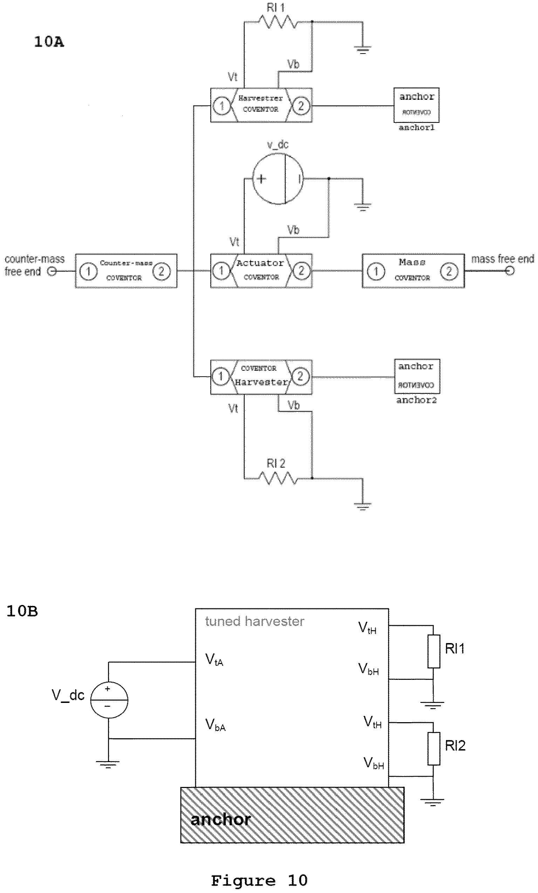

An electromechanical model of the device 100 is shown schematically in **Figure 10A**. $V\_dc$ denotes a DC voltage source that provides the required voltage for tuning the resonance frequency through the piezoelectric actuator. The DC voltage source $V\_dc$ may be a battery, a supercapcitor or any other suitable constant voltage source. R11 and R12 are schematic depictions of electronic circuits, for example WSN circuits, powered by the piezoelectric energy generators (harvesters). The circuits R11 and R12 may be substituted by a battery or a supercapcitor to store the harvested energy.

After tuning the device 100 to the target resonant frequency, the device 100 (tuned harvester) is firmly attached to an object that provides constant vibrations, for example the housing of a propeller (e.g. fan, cooler, air-conditioning pipe, etc.) or rotating machinery (e.g. rotor, motor, etc.). The machinery housing is schematically shown as "anchor" in **Figure 10B**. The device 100 may then harvest energy from the constant vibrations at the anchor, and the energy harvested by the device 100 may be used for monitoring the health of the machinery based on the vibration directly received, or for other purposes required by the electronic circuits R11 and R12.

In practice, one or more of the devices 100, 200, 800A and 800B may be implemented in an apparatus such as an WSN as described above for harvesting vibrational energy as electrical energy to power the apparatus. An example of such an apparatus may comprise an electronic circuit, a piezoelectric energy harvesting device such as the devices 100, 200, 800A and 800B, and means for distributing the charges generated by the device as electrical energy to the circuit for powering the circuit. As well as diverting the electrical energy to the circuit for immediate use, the distribution means may also comprise a battery for storing the charges generated by the device for later use, so that any surplus of energy is not wasted. The apparatus may be modified to accommodate a plurality of piezoelectric energy harvesting devices. In this case, each of the plurality of devices may be configured to operate either at the same or at different resonant frequencies, such that energy from vibrations at different frequencies can be harvested at the same time.

**Claims**

1. A piezoelectric energy harvesting device comprising:

   a cantilever arrangement having a first branch arranged to be anchored at one end;
   a first piezoelectric energy generator provided on the first branch for generating a charge when the cantilever arrangement is caused to deform;
   a mass coupled to the cantilever arrangement; and
   a counter-mass adapted to cooperate with the mass for determining a mode of vibration of the cantilever arrangement.

2. The device of claim 1 wherein the counter-mass is further adapted to co-operate with the mass for determining the stress distribution of the cantilever arrangement, such that the cantilever arrangement is subjected to tensile stress only or compressive stress only when the cantilever arrangement is caused to deform.

3. The device of claim 1 or 2 further comprising a second piezoelectric energy generator, wherein the cantilever arrangement further comprises a second branch arranged to be anchored at one end, and on which the second piezoelectric energy generator is provided for generating a charge when the cantilever arrangement is caused to deform, the first and second branches being coupled by the counter-mass at or towards the free end of the first and second branches.

4. The device of any of claim 1 to 3 further comprising a tuning means configured to adjust the resonant frequency of the cantilever arrangement, wherein the cantilever arrangement further comprises a third branch coupled to the first and second branches, the tuning means being provided on the third branch.

5. The device of claim 4 wherein the tuning means is a piezoelectric actuator arranged to vary the resonant frequency of the cantilever arrangement in accordance with a DC voltage applied thereto.

6. The device of claim 4 or 5 wherein the third branch is coupled to the first and second branches by the counter-mass and is positioned at or towards the free end of the first and second branches.

7. The device of claim 6 wherein the mass is coupled to the counter-mass by the third branch, the counter-mass being disposed at or towards the free end of the first and second branches, such that the mass is disposed in a region defined by the first, second and third branches.

8. The device of any of claim 5 to 7 wherein the piezoelectric material of the piezoelectric actuator comprises PZT, and/or the piezoelectric material of one or both of the first and second piezoelectric energy generators comprises AlN.

9. A micro-electro-mechanical system (MEMS) or a nano-electro-mechanical system (NEMS) comprising the device according to any preceding claim.

10. A method for manufacturing a piezoelectric energy harvesting device comprising the steps of:

   providing on a first branch of a cantilever arrangement that is anchored at one end with a first piezoelectric energy generator for generating a charge when the cantilever arrangement is caused to deform;
   setting a target resonant frequency and determining the weight of a mass and the weight of a counter-mass based on the target resonant frequency, such that the mass and the counter-mass cooperate to determine a mode of vibration of the cantilever arrangement; and
   coupling the mass and the counter-mass having the determined weights to the cantilever arrangement.

11. The method of claim 10, further comprising the step of providing a tuning means to a third branch of the cantilever arrangement, the third branch being coupled to the first and second branches, for adjusting the resonant frequency of the cantilever arrangement.

12. An apparatus for harvesting vibrational energy as electrical energy comprising a circuit, one or more of the devices according to any of claims 1 to 8, and distribution means for distributing the charges generated by the one or more devices as electrical energy to the circuit for powering the circuit.

13. The apparatus of claim 12 wherein the distribution means comprises storage means for storing the charges generated by the one or more devices.

14. The apparatus of claim 12 or 13 having a plurality of the devices wherein one or more of the plurality of devices are configured to operate at different resonant frequencies.

15. A method for harvesting energy from a source of vibration as electric energy using the device according to any of claim 5 to 9 when dependent on claim 5 comprising the steps of:

   disposing the device in the proximity of the source such that the vibration causes the cantilever arrangement to deform;
   collecting the charges produced, when the cantilever arrangement is deformed, by one or both of the first piezoelectric energy generator and the second piezoelectric energy generator; and
   adjusting the resonant frequency of the cantilever arrangement according to the vibration frequency of the source by varying the DC voltage applied to the piezoelectric actuator.

| AA' | | material | thickness [μm] |
|---|---|---|---|
| | | Al | 0.5 |
| | | AlN | 1 |
| | | Pt | 0.15 |
| | | SiO2 | 1 |
| | | Si | 50 |

1A

| BB' | | material | thickness [μm] |
|---|---|---|---|
| | | Al | 0.5 |
| | | PZT | 1 |
| | | Pt | 0.15 |
| | | SiO2 | 1 |
| | | Si | 50 |

1B

100

1D

120-1

160

120-3

130

120-2

110

A'

A

B — B'

C ——————— C'

1700μm    1000μm    2000μm

CC'    160    130    1C

Figure 1

200

Figure 2

Figure 3

Figure 4

Figure 5

| Properties | Piezoelectric Stress constant | | Piezoelectric Strain constant | | Dielectric constant |
|---|---|---|---|---|---|
| | e31 | e33 | d31 | d33 | $\varepsilon r$ |
| Units | C.m-2 | C.m-2 | pm.V-1 | pm.V-1 | - |
| PZT | -10 | 14 | -274 | 593 | 1700 |
| AlN | -0.58 | 1.55 | -2.65 | 5.53 | 8.8 |
| ZnO | -0.62 | 1.56 | -5 | 12 | 8.55 |
| BaTiO3 | -4.39 | 18 | -34.5 | 85.6 | 1400 |
| PVDF | 0.06 | 0.14 | 23 | -33 | 6.2 |

Figure 6

Figure 7

800A

820A

860A

810A

830A

800B

820B

860B

830B

810B

Figure 8

**9A**

```
┌─────────────────────────┐
│ Provide one or more     │
│ branches to substrate   │
└─────────────────────────┘
                    S0
            │
            ▼
┌─────────────────────────┐
│ Determine source        │
│ vibration frequency     │
└─────────────────────────┘
                    S1
            │
            ▼
┌─────────────────────────┐
│ Determine weight and    │
│ dimensions of mass and  │
│ counter-mass            │
└─────────────────────────┘
                    S2
            │
            ▼
┌─────────────────────────┐
│ Dispose mass and        │
│ counter-mass on device  │
└─────────────────────────┘
                    S3
```

**9B**

```
┌─────────────────────────┐
│ Dispose device near     │
│ vibration source        │
└─────────────────────────┘
                    S4
            │
            ▼
        ◇ Resonant frequency
          of device matches
          source vibration
          frequency?              NO
          │                        │
          │ YES                    ▼
          │            ┌─────────────────────────┐
          │            │ Tune device resonant    │
          │            │ frequency to match      │
          │            │ vibration source        │
          │            └─────────────────────────┘
          │                              S6
          ▼                        │
┌─────────────────────────┐        │
│ Collect charges at      │◄───────┘
│ harvesting branch(es)   │
└─────────────────────────┘
  S5
```

Figure 9

10A

10B

Figure 10

900

910

920

930

**11A**

1010

1000

1050

1040

1020

**11B**

Figure 11

Europäisches
Patentamt

European
Patent Office

Office européen
des brevets

# EUROPEAN SEARCH REPORT

Application Number

EP 12 15 0003

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 102 170 246 A (UNIV CHONGQING) 31 August 2011 (2011-08-31) | 1,2,8-10 | INV. H01L41/113 |
| Y | * paragraphs [0002], [0014], [0016], [0017]; figures 8-9 * | 1,3,9,10 | H02N2/18 |
| X | US 7 948 153 B1 (KELLOGG RICK A [US] ET AL) 24 May 2011 (2011-05-24) | 1,3,10 | |
| Y | * column 1, lines 57-63 * <br> * column 6, line 49 - column 7, line 25 * <br> * column 9, lines 35-50 * <br> * figure 7 * | 12-14 | |
| Y | JP 2005 057982 A (SHINOYAMA AKIMASA) 3 March 2005 (2005-03-03) <br> * paragraph [0020]; figures 1,7-9 * | 1,3,10 | |
| X | US 2011/304239 A1 (EICHHORM CHRISTOPH [DE] ET AL) 15 December 2011 (2011-12-15) | 1,4,5, 9-11,15 | |
| Y | * paragraphs [0015] - [0017], [0033], [0044], [0050]; figures 6-7 * | 9,12-14 | |
| Y | STEVEN R ANTON ET AL: "TOPICAL REVIEW; A review of power harvesting using piezoelectric materials (2003-2006)", SMART MATERIALS AND STRUCTURES, IOP PUBLISHING LTD., BRISTOL, GB, vol. 16, no. 3, 1 June 2007 (2007-06-01), pages R1-R21, XP020120492, ISSN: 0964-1726, DOI: 10.1088/0964-1726/16/3/R01 * page R15, column 1, paragraph 3 - page R16, column 2, paragraph 2 * | 9,12,13 | TECHNICAL FIELDS SEARCHED (IPC) <br> H01L <br> H02N |
| Y | US 2011/140578 A1 (KO SANG CHOON [KR] ET AL) 16 June 2011 (2011-06-16) <br> * paragraph [0043]; figure 3A * | 14 | |

The present search report has been drawn up for all claims

| Place of search | Date of completion of the search | Examiner |
|---|---|---|
| Munich | 31 May 2012 | Meul, Hans |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 12 15 0003

This annex lists the patent family members relating to the patent documents cited in the above-mentioned European search report.
The members are as contained in the European Patent Office EDP file on
The European Patent Office is in no way liable for these particulars which are merely given for the purpose of information.

31-05-2012

| Patent document<br>cited in search report | | Publication<br>date | Patent family<br>member(s) | | Publication<br>date |
|---|---|---|---|---|---|
| CN 102170246 | A | 31-08-2011 | NONE | | |
| US 7948153 | B1 | 24-05-2011 | NONE | | |
| JP 2005057982 | A | 03-03-2005 | NONE | | |
| US 2011304239 | A1 | 15-12-2011 | DE 102008056127 A1 | | 10-06-2010 |
| | | | EP 2361443 A1 | | 31-08-2011 |
| | | | US 2011304239 A1 | | 15-12-2011 |
| | | | WO 2010052009 A1 | | 14-05-2010 |
| US 2011140578 | A1 | 16-06-2011 | KR 20110066346 A | | 17-06-2011 |
| | | | US 2011140578 A1 | | 16-06-2011 |

EPO FORM P0459

For more details about this annex : see Official Journal of the European Patent Office, No. 12/82

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **BERDY et al.** Compact low frequency meandered piezoelectric energy harvester. *PowerMEMS,* December 2009

- **EICHHORN et al.** A piezoelectric harvester with an integrated frequency-tuning mechanism. *Power MEMS,* December 2009